# EUROPEAN PATENT SPECIFICATION

(11) **EP 4 390 613 B1**
(45) Date of publication and mention of the grant of the patent: **08.07.2026**
(21) Application number: 22873099.0
(22) Date of filing: 04.08.2022
(51) Int. Cl.: G06F 1/16, H04M 1/02

(54) **ELECTRONIC DEVICE COMPRISING DISPLAY SUPPORT MEMBER**
ELEKTRONISCHE VORRICHTUNG MIT ANZEIGETRÄGERELEMENT
DISPOSITIF ÉLECTRONIQUE COMPRENANT UN ÉLÉMENT DE SUPPORT D'ÉCRAN

(30) Priority: 27.09.2021 KR 20210127339
(43) Date of publication of application: 26.06.2024
(73) Proprietor: Samsung Electronics Co., Ltd., Suwon-si, Gyeonggi-do 16677 (KR)
(72) Inventor: KANG, Yuncheol, Suwon-si Gyeonggi-do 16677 (KR); HONG, Dongsool, Suwon-si Gyeonggi-do 16677 (KR); CHOI, Jongchul, Suwon-si Gyeonggi-do 16677 (KR)
(74) Representative: Appleyard Lees IP LLP
(86) International application number: PCT/KR2022/011578
(87) International publication number: WO 2023/048394

(56) References cited:
- WO-A1-2021/187834
- KR-A- 20160 029 543
- KR-A- 20190 110 689
- KR-A- 20190 114 863
- KR-A- 20200 049 925
- KR-A- 20200 064 376
- US-A1- 2018 356 859
- US-A1- 2020 321 551

## Description

### Technical Field

The present disclosure relates to an electronic device including a display support member.

### Background Art

Due to the advancement of information and communication technology and semiconductor technology, various functions are being integrated into a single portable electronic device. For example, an electronic device may implement not only communication functions, but also entertainment functions such as games, multimedia functions such as music/video playback, communication and security functions for mobile banking, schedule management functions, and electronic wallet functions. Such an electronic device is becoming smaller so that a user may conveniently carry the device.

As mobile communication services expand into the area of multimedia services, there is a need to increase the size of a display of an electronic device so that a user may fully utilize multimedia services as well as voice calls and short messages services. However, the size of a display of an electronic device is in a trade-off relationship with the miniaturization of the electronic device. KR 2019/0114863 A discloses a portable terminal with a foldable display and, more specifically, to a portable terminal with a foldable display which has a flexible display to be folded and unfolded by an external force. US 2018/356859 A1 discloses A foldable display of a computing device includes a back stiffening layer, a transparent front plate layer, a transparent cover window layer, and an OLEO display layer disposed between the back stiffening layer and the transparent front plate layer. US 2020/321551 A1 discloses flexible display device includes a magnetic body group, which is adhered to a lower plate provided under a display panel by the force of magnetic attraction.

### Detailed Description of the Invention

### Technical Solution

According to an embodiment of the disclosure, an electronic device may include a housing including a first housing and a second housing configured to rotate with respect to the first housing, a display including a first display area disposed on the first housing, a second display area disposed on the second housing, and a folding area positioned between the first display area and the second display area, and a display support member formed of a composite material and configured to support the display. The display support member may include a pattern structure facing the folding area. The pattern structure may include a wing portion and a support portion extending from the wing portion.

According to an embodiment of the disclosure, an electronic device may include a housing including a first housing and a second housing configured to rotate with respect to the first housing, a display including a first display area disposed on the first housing, a second display area disposed on the second housing, and a folding area positioned between the first display area and the second display area, a hinge module connected to the first housing and the second housing, and a display support member formed of a composite material and configured to support the display. The display support member may include a pattern structure positioned between the folding area and the hinge module. The pattern structure may include a wing portion and a support portion extending from the wing portion, and a second thickness of the wing portion may be smaller than a first thickness of the support portion.

### Brief Description of Drawings

FIG. 1 is a diagram illustrating an unfolded state of an electronic device, according to an embodiment of the disclosure;
FIG. 2 is a diagram illustrating a folded state of an electronic device, according to an embodiment of the disclosure;
FIG. 3 is an exploded perspective view of an electronic device, according to an embodiment of the disclosure;
FIG. 4 is a cross-sectional view of an electronic device including a display and a display support member, according to an embodiment of the disclosure;
FIG. 5 is a front view of a display support member, according to an embodiment of the disclosure;
FIG. 6 is a schematic view of a display support member, according to an embodiment of the disclosure;
FIG. 7A is a front view of a display support member, according to an embodiment of the disclosure, and FIGS. 7B to 7D are cross-sectional views taken along line A-A' in FIG. 7A;
FIG. 8A is a front view of a display support member, according to an embodiment of the disclosure, and FIGS. 8B to 8C are cross-sectional views taken along line B-B' in FIG. 8A;
FIG. 9A is a front view of a display support member, according to an embodiment of the disclosure, and FIG. 9B is a cross-sectional view taken along line C-C' in FIG. 9A;
FIG. 10A is an enlarged view of area A of a display support member, according to an embodiment of the disclosure, and FIGS. 10B and 10C are cross-sectional views of the display support member in FIG. 10A; and
FIGS. 11A and 11B are front views of a display support member including a pattern structure having various shapes, according to an embodiment of the disclosure.

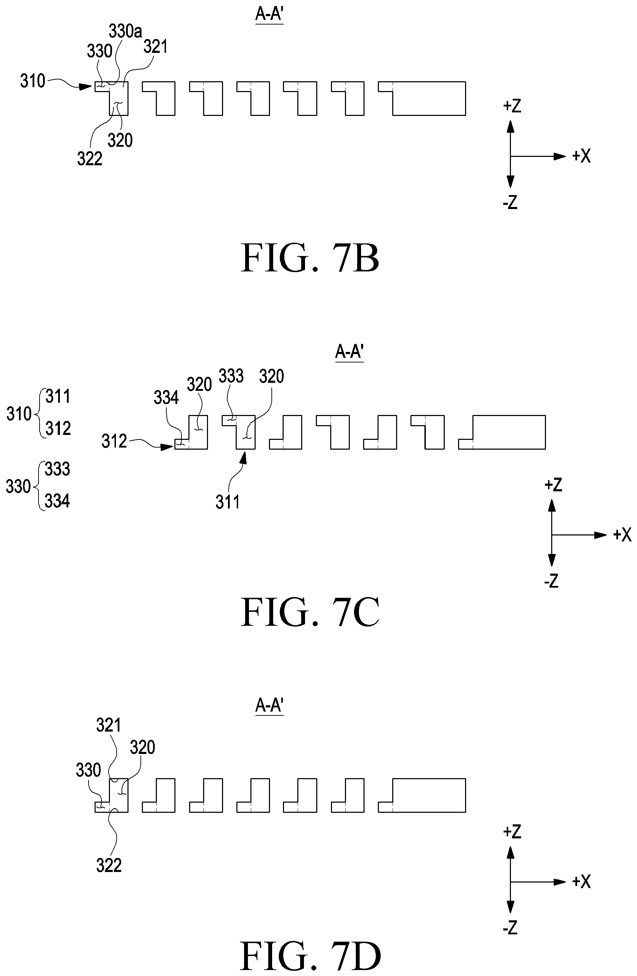

FIGS. 7B, 7D and 8A-10B are views of display support members according to non-claimed examples, useful to understand the background of the invention.

### Mode for Carrying out the Invention

The electronic device according to various embodiments disclosed herein may be one of various types of electronic devices. The electronic devices may include, for example, a portable communication device (e.g., a smart phone), a computer device, a portable multimedia device, a portable medical device, a camera, a wearable device, or a home appliance. The electronic device according to embodiments of the disclosure is not limited to those described above.

With regard to the description of the drawings, similar reference numerals may be used to designate similar or relevant elements. A singular form of a noun corresponding to an item may include one or more of the items, unless the relevant context clearly indicates otherwise. As used herein, each of such phrases as "A or B," "at least one of A and B," "at least one of A or B ," "A, B, or C," "at least one of A, B, and C," and "at least one of A, B, or C" may include all possible combinations of the items enumerated together in a corresponding one of the phrases. As used herein, such terms as "a first", "a second", "the first", and "the second" may be used to simply distinguish a corresponding element from another. It is to be understood that if an element (e.g., a first element) is referred to, with or without the term "operatively" or "communicatively", as "coupled with/to" or "connected with/to" another element (e.g., a second element), it means that the element may be coupled/connected with/to the other element directly (e.g., wiredly), wirelessly, or via a third element.

As used in various embodiments of the disclosure, the term "module" may include a unit implemented in hardware, software, or firmware, and may be interchangeably used with other terms, for example, "logic," "logic block," "component," or "circuit". The "module" may be a minimum unit of a single integrated component adapted to perform one or more functions, or a part thereof. For example, according to an embodiment, the "module" may be implemented in the form of an application-specific integrated circuit (ASIC).

According to various embodiments, each element (e.g., a module or a program) of the above-described elements may include a single entity or multiple entities, and some of the multiple entities may be separately disposed in any other element. According to various embodiments, one or more of the above-described elements may be omitted, or one or more other elements may be added. Alternatively or additionally, a plurality of elements (e.g., modules or programs) may be integrated into a single element. In such a case, according to various embodiments, the integrated element may still perform one or more functions of each of the plurality of elements in the same or similar manner as they are performed by a corresponding one of the plurality of elements before the integration.

According to various embodiments, operations performed by the module, the program, or another element may be carried out sequentially, in parallel, repeatedly, or heuristically, or one or more of the operations may be executed in a different order or omitted, or one or more other operations may be added.

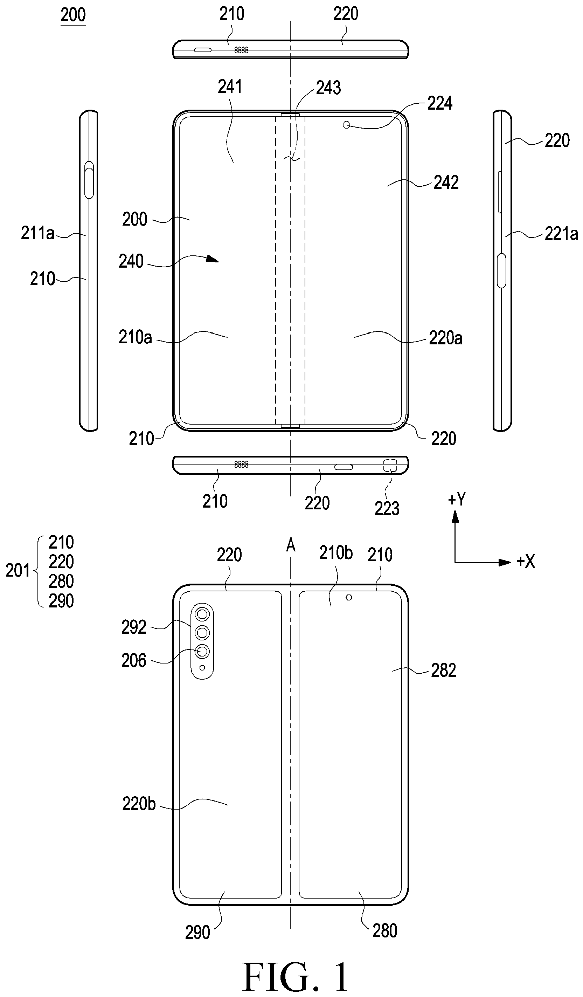

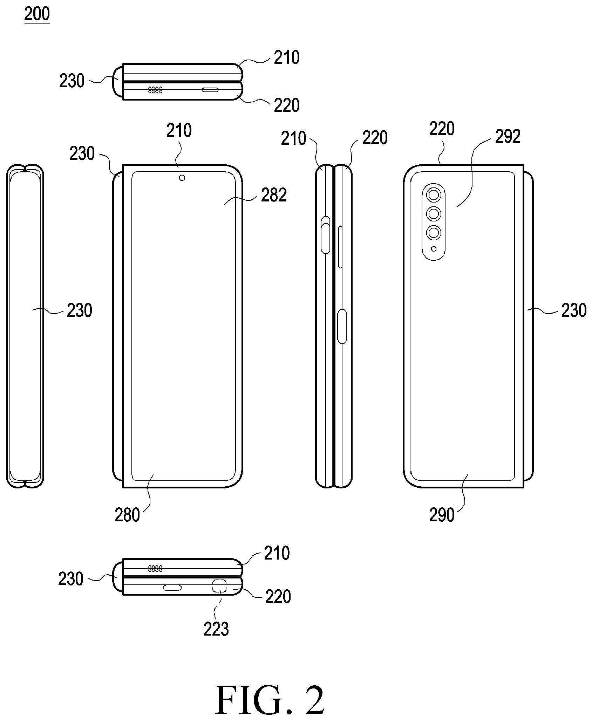

FIG. 1 is a diagram illustrating an unfolded state of an electronic device, according to an embodiment of the disclosure. FIG. 2 is a diagram illustrating a folded state of an electronic device, according to an embodiment of the disclosure.

Referring to FIG. 1 and FIG. 2, in an embodiment, an electronic device 200 may include a housing 201, a hinge cover 230 configured to cover a foldable portion of the housing 201, and a flexible or foldable display 240 (hereinafter, shortly "display" 240) disposed in a space formed by the housing 201. According to an embodiment, a surface on which the display 240 is disposed is defined as a front surface (e.g., a first front surface 210a and a second front surface 220a) of the electronic device 200. Further, a surface opposite to the front surface is defined as a rear surface (e.g., a first rear surface 210b and a second rear surface 220b) of the electronic device 200. In addition, a surface surrounding a space between the front surface and the rear surface is defined as a lateral surface (e.g., a first lateral surface 211a and a second lateral surface 221a) of the electronic device 200.

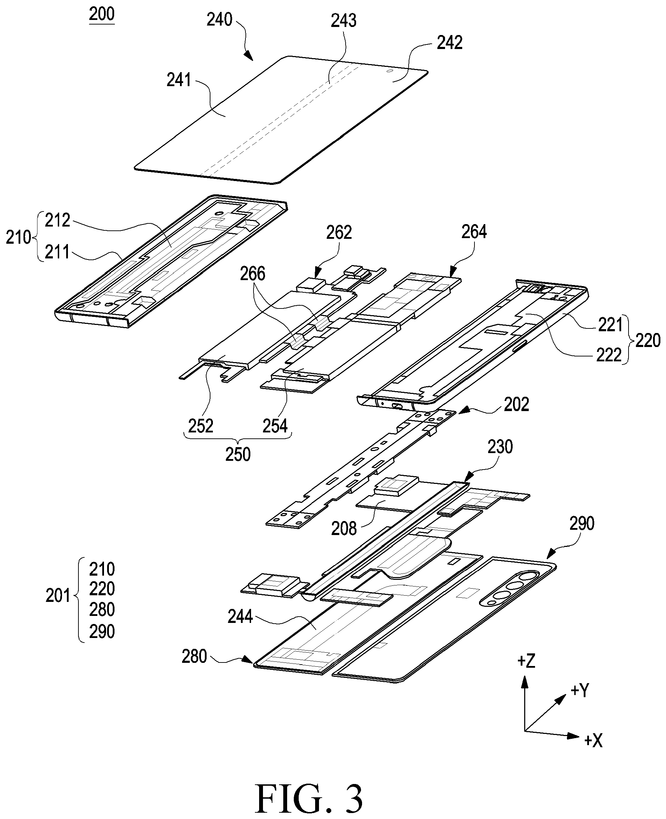

According to an embodiment, the housing 201 may include a first housing 210, a second housing 220 which is rotatable to the first housing 210, a first rear cover 280, a second rear cover 290, and a hinge module (e.g., the hinge module 202 in FIG. 3). The housing 201 of the electronic device 200 is not limited to the form and combination shown in FIG. 2 and FIG. 3, and may be implemented by the combination and/or coupling of other shapes or parts. For example, in another embodiment, the first housing 210 and the first rear cover 280 may be integrally formed, and the second housing 220 and the second rear cover 290 may be integrally formed. According to an embodiment, the first housing 210 may be connected to the hinge module 202 and may include a first front surface 210a directed in a first direction and a first rear surface 210b directed in a second direction opposite to the first direction. The second housing 220 may be connected to the hinge module 202, may include a second front surface 220a directed in a third direction and a second rear surface 220b directed in a fourth direction opposite to the third direction, and may rotate with respect to the first housing 210 around the hinge module 202. Accordingly, the state of the electronic device 200 may vary to a folded or unfolded state. In the folded state of the electronic device 200, the first front surface 210a may face the second front surface 220a, and in the unfolded state, the third direction may be the same as the first direction. Hereinafter, unless otherwise described, the direction in the description of the disclosure will be based on the unfolded state of the electronic device 200.

According to an embodiment, the first housing 210 and the second housing 220 may be arranged on both sides of a folding axis (A) and may have an overall symmetrical shape with respect to the folding axis (A). As will be described later, the angle or distance between the first housing 210 and the second housing 220 may vary depending on whether the electronic device 200 is in an unfolded state, a folded state, or an intermediate state. According to an embodiment, the second housing 220, unlike the first housing 210, may additionally include a sensor area 224 in which various sensors (e.g., front cameras) are placed, but may have a mutually symmetrical shape in other areas. According to an embodiment, the folding axis (A) may be multiple (e.g., two) parallel folding axes. In the disclosure, the folding axis (A) is provided along the longitudinal direction (Y-axis direction) of the electronic device 200, but the direction of the folding axis (A) is not limited thereto. For example, the electronic device 200 may include a folding axis (A) extending along the width direction (e.g., the X-axis direction).

According to an embodiment, the electronic device 200 may include a structure into which a digital pen may be inserted. For example, a hole 223 into which the digital pen may be inserted may be formed on a lateral surface of the first housing 210 or a lateral surface of the second housing 220 of the electronic device 200.

According to an embodiment, at least a portion of the first housing 210 and the second housing 220 may be configured of a metallic or non-metallic material having the rigidity of a selected magnitude to support the display 240. At least a portion configured of the metallic material may provide a ground plane of the electronic device 200 and may be electrically connected to a ground line formed on a printed circuit board (e.g., a substrate unit 260 in FIG. 3).

According to an embodiment, the sensor area 224 may be configured to have a predetermined area adjacent to one corner of the second housing 220. The arrangement, shape, and size of the sensor area 224 are not limited to the illustrated examples. For example, in another embodiment, the sensor area 224 may be provided in another corner of the second housing 220, in any area between the top and bottom corners, or in the first housing 210. According to an embodiment, components configured to perform various functions built in the electronic device 200 may be visually exposed on the front surface of the electronic device 200 via the sensor area 224 or through at least one opening provided in the sensor area 224. In various embodiments, the components may include various kinds of sensors. For example, the sensor may include at least one among a front camera, a receiver, or a proximity sensor.

According to an embodiment, the first rear cover 280 may be disposed on one side of the folding axis (A) at the rear surface of the electronic device 200, and may have, for example, a substantially rectangular periphery, and the periphery may be surrounded by the first housing 210. Similarly, the second rear cover 290 may be disposed on the other side of the folding axis (A) at the rear surface of the electronic device 200, and the periphery of the second rear cover may be surrounded by the second housing 220.

According to an embodiment, the first rear cover 280 and the second rear cover 290 may have a substantially symmetrical shape about the folding axis (A-axis). The first rear cover 280 and the second rear cover 290 do not necessarily have a mutually symmetrical shape, and in another embodiment, the electronic device 200 may include a first rear cover 280 and a second rear cover 290 having various shapes.

According to an embodiment, the first rear cover 280, the second rear cover 290, the first housing 210, and the second housing 220 may form a space in which various components (e.g., a printed circuit board or a battery) of the electronic device 200 may be arranged. According to an embodiment, one or more components may be arranged or visually exposed on the rear surface of the electronic device 200. For example, at least a portion of a sub-display (e.g., a sub-display 244 in FIG. 3) may be visually exposed via the first rear area 282 of the first rear cover 280. In another embodiment, one or more components or sensors may be visually exposed via a second rear area 292 of the second rear cover 290. In various embodiments, the sensor may include a proximity sensor and/or a camera module 206 (e.g., a rear camera).

According to an embodiment, the front camera visually exposed on the front surface of the electronic device 200 through at least one opening provided in the sensor area 224 or the camera module 206 visually exposed via the second rear area 292 of the second rear cover 290 may include one or more lenses, image sensors, and/or image signal processors. In an embodiment, two or more lenses (an infrared camera, a wide-angle lens, and a telephoto lens) and image sensors may be arranged on one surface of the electronic device 200.

Referring to FIG. 2, the hinge cover 230 may be configured to be disposed between the first housing 210 and the second housing 220 to cover internal components (e.g., the hinge module 202 in FIG. 3). According to an embodiment, the hinge cover 230 may be covered by a portion of the first housing 210 and the second housing 220 or may be exposed to the outside, depending on the state (the unfolded state (flat state) or the folded state) of the electronic device 200.

According to an embodiment, as shown in FIG. 1, when the electronic device 200 is in the unfolded state, the hinge cover 230 may be covered by the first housing 210 and the second housing 220 and may be prevented from being exposed. As another example, as shown in FIG. 2, when the electronic device 200 is in the folded state (e.g., the fully folded state), the hinge cover 230 may be exposed to the outside between the first housing 210 and the second housing 220. As still another example, when the electronic device is in the intermediate state in which the first housing 210 and the second housing 220 make a predetermined angle with respect to each other (folded with a certain angle), the hinge cover 230 may be partially exposed to the outside between the first housing 210 and the second housing 220. The exposed area in the intermediate state may be smaller than that in the fully folded state. In an embodiment, the hinge cover 230 may include a curved surface.

According to an embodiment, the display 240 may be disposed in a space formed by the housing 201. For example, the display 240 may be seated on a recess formed by the housing 201 and may constitute most of the front surface of the electronic device 200. Accordingly, the front surface of the electronic device 200 may include the display 240, a partial area of the first housing 210 adjacent to the display 240, and a partial area of the second housing 220. The rear surface of the electronic device 200 may include the first rear cover 280, a partial area of the first housing 210 adjacent to the first rear cover 280, the second rear cover 290, and a partial area of the second housing 220 adjacent to the second rear cover 290.

According to an embodiment, the display 240 may indicate a display in which at least a partial area may be transformed into a flat or curved surface. According to an embodiment, the display 240 may include a folding area 243, a first display area 241 disposed on one side of the folding area 243 (e.g., the left side of the folding area 243 shown in FIG. 1) and a second display area 242 disposed on the other side thereof (e.g., the right side of the folding area 243 shown in FIG. 1).

The division of the areas of the display 240 is an example, and the display 240 may be divided into a plurality of areas (for example, four or more or two) depending on the structure or function. For example, in the embodiment shown in FIG. 1, the area of the display 240 may be divided by the folding area 243 or the folding axis (A-axis) extending to be parallel to the Y-axis, but in another embodiment, the display 240 may be divided into areas based on a different folding area (e.g., a folding area parallel to the X axis) or a different folding axis (e.g., a folding axis parallel to the X axis). According to an embodiment, the display 240 may be coupled to or disposed adjacent to a touch detection circuit, a pressure sensor capable of measuring the magnitude (pressure) of touch, and/or a digitizer (not shown) configured to detect a magnetic field-type stylus pen.

According to an embodiment, the first display area 241 and the second display area 242 may have an overall symmetrical shape around the folding area 243. According to an embodiment (not shown), the second display area 242, unlike the first display area 241, may include a cut notch depending on the presence of the sensor area 224, but, in the area other than the sensor area, may have a symmetrical shape with the first display area 241. In other words, the first display area 241 and the second display area 242 may include portions having mutually symmetrical shapes and portions having mutually asymmetrical shapes, respectively.

Hereinafter, the operation of the first housing 210 and the second housing 220 and each area of the display 240 according to the state (e.g., the unfolded state (or the flat state) and the folded state) of the electronic device 200 will be described.

According to an embodiment, when the electronic device 200 is in an unfolded state (a flat state) (e.g., FIG. 2), the first housing 210 and the second housing 220 may be arranged to be directed in the same direction while forming an angle of substantially 180 degrees. The surface of the first display area 241 and the surface of the second display area 242 of the display 240 may form an angle of 180 degrees to each other and may be directed in the same direction (e.g., the direction of the front surface of the electronic device). The folding area 243 may form the same plane as the first display area 241 and the second display area 242.

According to an embodiment, when the electronic device 200 is in a folded state (e.g., FIG. 3), the first housing 210 and the second housing 220 may be arranged to face each other. The surface of the first display area 241 and the surface of the second display area 242 of the display 240 may form a narrow angle (e.g., between 0 degrees and 10 degrees) while facing each other. At least a portion of the folding area 243 may be formed of a curved surface having a predetermined curvature.

According to an embodiment, when the electronic device 200 is in an intermediate state (a folded state) (e.g., FIG. 3), the first housing 210 and the second housing 220 may be arranged to have a certain angle with respect to each other. The surface of the first display area 241 and the surface of the second display area 242 of the display 240 may form an angle which is larger than that in the folded state and smaller than that in the unfolded state. At least a portion of the folding area 243 may be formed of a curved surface having a predetermined curvature, and the curvature may be smaller than that in the folded state.

FIG. 3 is an exploded perspective view of an electronic device, according to an embodiment of the disclosure.

Referring to FIG. 3, the electronic device 200 may include a housing 201, a display 240, a hinge module 202, a battery 250, and a substrate unit 260. The housing 201 may include a first housing 210, a second housing 220, a first rear cover 280, and a second rear cover 290.

According to an embodiment, the housing 201 may include a first housing 210, a second housing 220, a hinge cover 230, a first rear cover 280, and a second rear cover 290. The configurations of the first housing 210, the second housing 220, the hinge cover 230, the first rear cover 280, and the second rear cover 290 in FIG. 3 may be partially or totally the same as those of the first housing 210, the second housing 220, the hinge cover 230, the first rear cover 280, and the second rear cover 290 in FIG. 1 and/or FIG. 2.

According to an embodiment, the first housing 210 and the second housing 220 may be assembled with each other to be coupled to opposite sides of the hinge module 202. According to an embodiment, the first housing 210 may include a first support area 212 capable of supporting components of the electronic device 200 (e.g., a first circuit board 262 and/or a first battery 252) and a first lateral wall 211 surrounding at least a portion of the first support area 212. The first lateral wall 211 may include a first lateral surface of the electronic device 200 (e.g., the first lateral surface 211a in FIG. 2). According to an embodiment, the second housing 220 may include a second support area 222 capable of supporting components of the electronic device 200 (e.g., a second circuit board 264 and/or a second battery 254) and a second lateral wall 221 surrounding at least a portion of the second support area 222. The second lateral wall 221 may include a second lateral surface (e.g., the second lateral surface 221a in FIG. 2) of the electronic device 200.

According to an embodiment, the display 240 may include a first display area 241, a second display area 242, a folding area 243, and a sub-display 244. The configurations of the first display area 241, the second display area 242, and the folding area 243 in FIG. 3 may be partially or totally the same as those of the first display area 241, the second display area 242, and the folding area 243 in FIG. 1 and/or FIG. 2.

According to an embodiment, the sub-display 244 may display the screen in a different direction from the display areas 241 and 242. For example, the sub-display 244 may display the screen in the opposite direction of the first display area 241. According to an embodiment, the sub-display 244 may be disposed on the first rear cover 280.

According to an embodiment, the battery 250 (e.g., a battery 189 in FIG. 1) may include a first battery 252 disposed within the first housing 210 and a second battery 254 disposed within the second housing 220. According to an embodiment, the first battery 252 may be disposed on the first circuit board 262, and the second battery 254 may be disposed on the second circuit board 264.

According to an embodiment, the substrate unit 260 may include a first circuit board 262 disposed within the first housing 210 and a second circuit board 264 disposed within the second housing 220. According to an embodiment, the substrate unit 260 may include at least one flexible circuit board 266 configured to electrically connect the first circuit board 262 and the second circuit board 264. According to an embodiment, at least a portion of the flexible circuit board 266 may be disposed across the hinge module 202. According to an embodiment, the first circuit board 262 and the second circuit board 264 may be arranged inside the space formed by the first housing 210, the second housing 220, the first rear cover 280, and the second rear cover 290. Components may be arranged on the first circuit board 262 and the second circuit board 264 to implement various functions of the electronic device 200.

According to an embodiment, the electronic device 200 may include a speaker module 208 (e.g., an audio module 170 in FIG. 1). According to an embodiment, the speaker module 208 may convert electrical signals into sound. According to an embodiment, the speaker module 208 may be disposed inside the space formed by the first housing 210, the second housing 220, the first rear cover 280, and the second rear cover 290.

In the detailed description below, a configuration in which a pair of housings (or, referred to as a "housing") are rotatably coupled by a hinge module (or, referred to as 'hinge structure') may be shown as an example. However, it should be noted that this embodiment does not limit the electronic device according to embodiments disclosed herein. For example, an electronic device according to an embodiment disclosed herein may include three or more housings, and in the embodiment disclosed below, "a pair of housings" may indicate "two housings of three or more housings, the two housings being rotatably coupled to each other".

The electronic device 200 disclosed in FIGS. 1 to 3 has the appearance of a foldable electronic device, but the disclosure is not limited thereto. For example, the illustrated electronic device may be a bar type, plate type, or rollable electronic device. "A rollable electronic device" may indicate an electronic device in which a display (e.g., the display 240 in FIG. 3) is capable of bending deformation so that at least a portion of the display is wound, rolled, or received inside the housing (e.g., the housing 201 in FIG. 1). Depending on the user's needs, the rollable electronic device may unroll the display to expose a larger area of the display to the outside, and thus may be used to expand the screen display area.

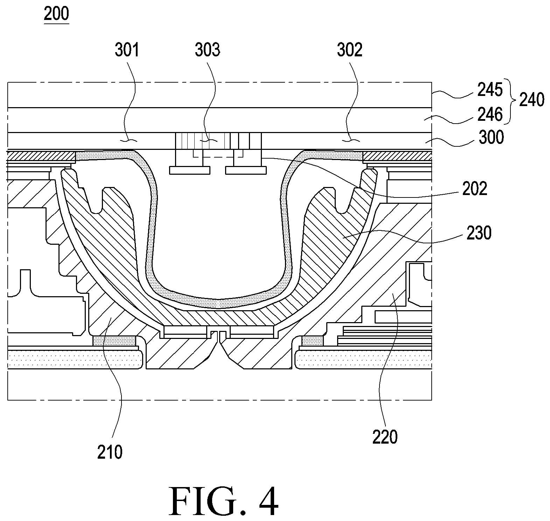

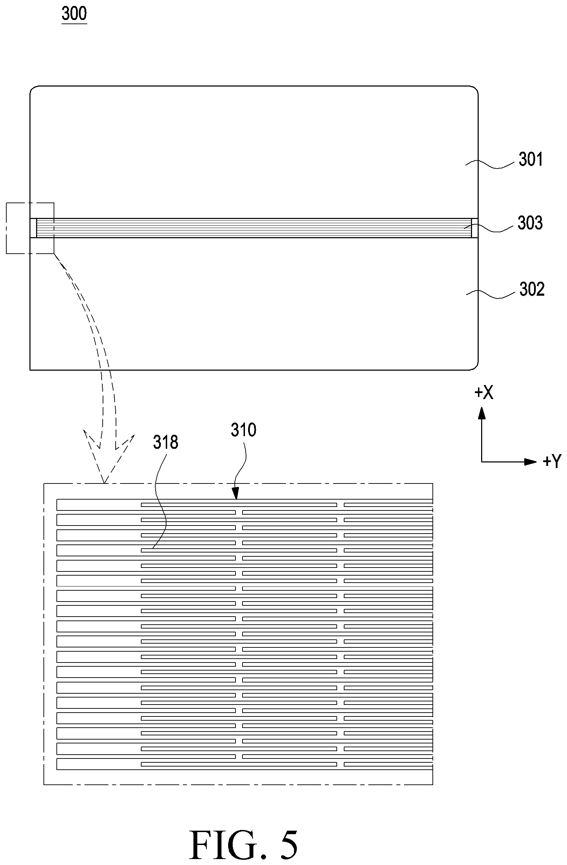

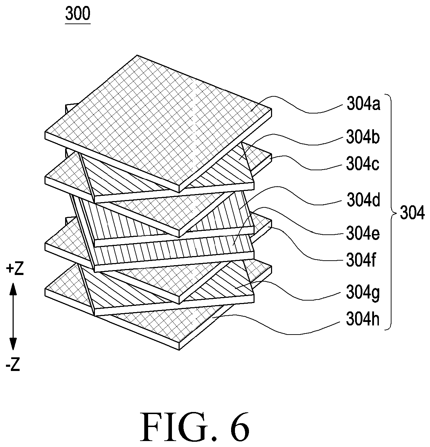

FIG. 4 is a cross-sectional view of an electronic device including a display and a display support member, according to an embodiment of the disclosure. FIG. 5 is a front view of a display support member, according to an embodiment of the disclosure. FIG. 6 is a schematic view of a display support member, according to an embodiment of the disclosure.

Referring to FIGS. 4 to 6, an electronic device 200 may include a display 240 and a display support member 300. The configuration of a first housing 210, a second housing 220, and the display 240 in FIG. 4 may be partially or totally the same as the configuration of the display 240 in FIG. 1 and/or FIG. 3.

According to an embodiment, the display 240 includes a display panel 245 and a pen driving circuit 246 configured to display visual information. According to an embodiment, the pen driving circuit 246 may transmit electromagnetic field signals. For example, the pen driving circuit 246 may resonate the resonance circuit of an electronic pen, and may radiate an electro-magnetic resonance (EMR) input signal by resonance. The electronic device 200 may use the electromagnetic resonance input signal to identify the position of the electronic pen (not shown) with respect to the electronic device 200. According to an embodiment, the electronic device 200 may identify electric potentials in a plurality of channels (e.g., electrodes) due to resonance in the electronic pen, and may also identify the location of the electronic pen based on the electric potential. A person skilled in the art will understand that the electronic pen may be implemented in an active electrostatic (AES) method and there is no limitation in the type of implementation. According to an embodiment, the electronic device 200 may detect the location of the electronic pen based on a change in the capacitance (self-capacitance or mutual capacitance) associated with at least one electrode of a touch panel.

According to an embodiment, the display support member 300 support at least a portion of the display 240. For example, the display 240 may support the display 240 together with the housing 201. According to an embodiment, the display support member 300 may reduce tensile stress applied to the display 240. According to an embodiment, the display support member 300 may be attached to the display 240 using an adhesive member (not shown).

According to an embodiment, the display support member 300 may be formed in a shape which may be bent based on the folding of the electronic device 200. According to an embodiment, the display support member 300 may include a first area 301 supporting a first display area (e.g., the first display area 241 in FIG. 3), a second area 302 supporting a second display area (e.g., the second display area in FIG. 3) and a third area 303 supporting a folding area (e.g., the folding area 243 in FIG. 3). According to an embodiment, the first area 301 and/or the second area 302 may be formed to be substantially flat. According to an embodiment, the third area 303 may be located between the first area 301 and the second area 302.

According to an embodiment, the third area 303 may include a pattern structure 310. According to an embodiment, the pattern structure 310 may provide a recess including a groove or a through-hole. For example, the pattern structure 310 may include at least one through-hole 318. According to an embodiment, at least a portion of the pattern structure 310 may face at least a portion of the folding area 243 of the display 240. According to an embodiment, the flexibility of the third area 303 including the pattern structure 310 may be greater than that of the first area 301 and/or the second area 302.

According to an embodiment, the display support member 300 includes a composite material. According to an embodiment, the composite material may be carbon fiber reinforced plastic (CFRP). The carbon fiber reinforced plastic may include carbon fiber and synthetic resin. According to an embodiment, the composite material may include fiberglass. For example, the composite material may be glass fiber reinforced plastic (GFRP). According to an embodiment, the display support member 300 may include a substantially non-conductive material, and distortion of the signal produced in the pen driving circuit 246 by the display support member 300 may be reduced.

According to an embodiment, the display support member 300 may include a plurality of prepreg layers 304. According to an embodiment, the prepreg layers 304 may include carbon fiber reinforced plastic. According to an embodiment, the prepreg layers 304 of the display support member 300 may be formed using fiber spreading technology (tow spreading technology). For example, the prepreg layers 304 may be thin ply prepreg. According to an embodiment, the thickness of one prepreg layer 304a, 304b, 304c, 304d, 304e, 304f, 304g, or 304h may be 0.1 mm to 0.2 mm.

According to an embodiment, the prepreg layers 304 may include a plurality of prepreg layers 304a, 304b, 304c, 304d, 304e, 304f, 304g, and 304h. According to an embodiment, the plurality of prepreg layers 304a, 304b, 304c, 304d, 304e, 304f, 304g, and 304h may be arranged along at least one different direction. According to an embodiment, the prepreg layers 304 may include at least one first prepreg layer 304b, 304d, 304e, and 304g each arranged along one direction (uni-directional) and/or at least one second prepreg layer 304a, 304c, 304f, and 304h arranged along various directions (multidirectional). According to an embodiment, the at least one first prepreg layer 304b, 304d, 304e, and 304g may include fibers (tow) arranged along one direction. According to an embodiment, the at least one first prepreg layer 304b, 304d, 304e, and 304g may be arranged along a different single direction. According to an embodiment, the at least one second prepreg layer 304a, 304c, 304f, and 304h may include fibers arranged along various directions. For example, the second prepreg layers 304a, 304c, 304f, and 304h may include interwoven fibers. According to an embodiment, the prepreg layers 304 may be interpreted as a structure in which a plurality of prepreg layers 304a, 304b, 304c, 304d, 304e, 304f, 304g, and 304h are stacked at different angles. For example, the prepreg layers 304 may include a plurality of prepreg layers 304a, 304b, 304c, 304d, 304e, 304f, 304g, and 304h, each arranged along a different direction. According to an embodiment, the plurality of prepreg layers 304 may be stacked in a symmetric direction or an asymmetric direction. According to an embodiment, the plurality of prepreg layers 304 may include fibers arranged along different directions, and thus the resistance to external impact of the display support member 300 may be increased. For example, the fatigue failure resistance of the prepreg layers 304 including fibers arranged along different directions may be greater than the fatigue failure resistance of prepreg layers (not shown) including fibers arranged along the same direction. According to an embodiment, the plurality of the prepreg layers 304 may include fibers arranged along different directions, and thus, the heat dissipation effect of the display support member 300 may be increased.

In the disclosure, the display 240 and the display support member 300 are shown as separate elements, but the disclosure is not limited thereto. For example, in an embodiment (not shown), the display 240 may be interpreted as an element including the display support member 300.

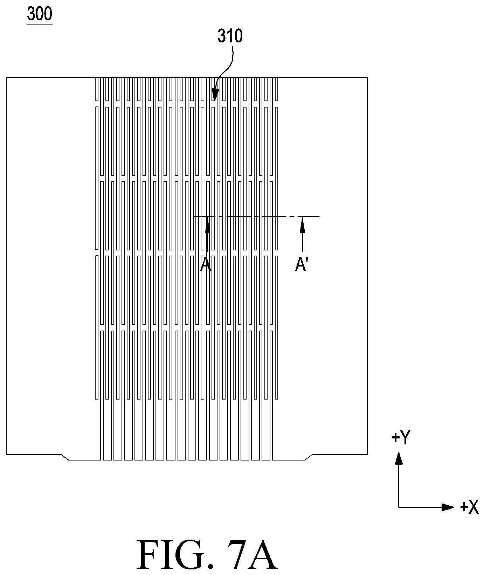

FIG. 7A is a front view of a display support member, according to an embodiment of the disclosure, and FIGS. 7B to 7D are cross-sectional views taken along line A-A' in FIG. 7A.

Referring to FIGS. 7A to 7D, the display support member 300 includes a pattern structure 310. The configurations of the display support member 300 and the pattern structure 310 in FIGS. 7A, 7B, 7C, and/or 7D may be partially or totally the same as those of the display support member 300 and the pattern structure 310 in FIG. 5.

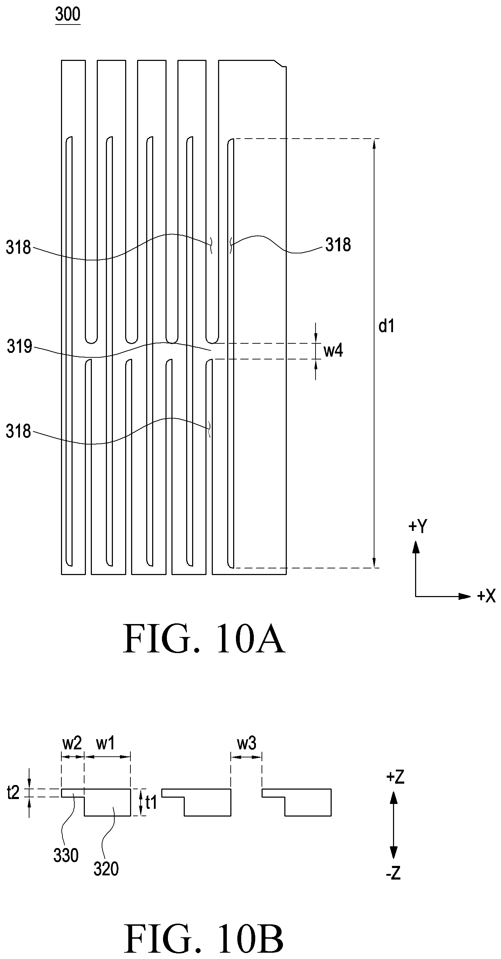

According to an embodiment, the pattern structure 310 includes a support portion 320 and a wing portion 330. According to an embodiment, the support portion 320 may be interpreted as a portion of the display support member 300 formed along a direction (e.g., the Z-axis direction) substantially perpendicular to the display (e.g., the display 240 in FIG. 3). For example, the support portion 320 may extend in a second direction (the Z-axis direction), which is the thickness direction (Z-direction) of the electronic device 200. According to an embodiment, the wing portion 330 may be interpreted as a portion of the display support member 300 formed in a direction (e.g., X-axis direction) substantially parallel to at least a portion of the display (e.g., the display 240 in FIG. 3). For example, the wing portion 330 may extend in a first direction (the X-axis direction), which is the width direction of the electronic device 200. For example, the support portion 320 may be formed to be substantially perpendicular to the wing portion 330. According to an embodiment, the wing portion 330 may be interpreted as a structure extending from the support portion 320 in the width direction (the X-axis direction). According to an embodiment, the support portion 320 may be interpreted as a structure extending from the wing portion 330 in the second direction (the Z-axis direction). For example, a second thickness of the wing portion 330 (e.g., a second thickness t2 in FIG. 10B) may be thinner than a first thickness of the support portion 320 (e.g., a first thickness t1 in FIG. 10B). According to an embodiment, the pattern structure 310 may include a plurality of support portions 320 and a plurality of wing portions 330. For example, the pattern structure 310 may be interpreted as a pattern formed by a plurality of support portions 320 and a plurality of wing portions 330.

According to an embodiment, at least a portion of the support portion 320 may support a display (e.g., the display 240 in FIG. 4). According to an embodiment, the support portion 320 may include a first end area 321 facing at least a portion of the display and a second end area 322 opposite to the first end area 321. The second end area 322 may face the inside of the electronic device 200. According to an embodiment, the wing portion 330 may extend along the first direction (the X-axis direction) from the first end area 321 or the second end area 322 of the support portion 320.

According to an embodiment (e.g., FIG. 7B), the wing portion 330 may extend from the first end area 321 of the support portion 320. The wing portion 330 may support at least a portion of the display (e.g., the display 240 in FIG. 4). For example, the wing portion 330 may include a first surface 330a facing at least a portion of the display 240. According to an embodiment, the area of the display support member 300 supporting the display 240 may be increased by the wing portion 330, and thus the degree to which the pressure applied to the display 240 (e.g., pen pressure of a digital pen) is distributed may increase to increase user convenience, and the degree to which the display support member 300 is visually exposed to the outside of the electronic device 200 may decrease. According to an embodiment, the cross-sectional shape of the pattern structure 310 may be formed in a " 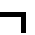 " shape.

According to an embodiment (e.g., FIG. 7D), the wing portion 330 may extend from the second end area 322 of the support portion 320. For example, the first end area 321 of the support portion 320 may support at least a portion of the display (e.g., the display 240 in FIG. 4), and the wing portion 330 may be spaced apart from the display 240. According to an embodiment, the flexibility of the third area 303 of the display support member 300 may be increased by the wing portion 330 extending from the second end area 322. According to an embodiment, the cross-sectional shape of the pattern structure 310 may be formed in a " 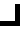 " shape.

According to an embodiment (e.g., FIG. 7C), the pattern structure 310 may include a first pattern structure 311 including a first wing portion 333 extending from the first end area 321 of the support portion 320 and a second pattern structure 312 including a second wing portion 334 extending from the second end area 322 of the support portion 320. For example, a portion of the wing portion 330 may extend from the first end area 321 of the support portion 320, and another portion thereof may extend from the second end area 322 of the support portion 320. According to an embodiment, the first pattern structure 311 and the second pattern structure 312 may be arranged alternately. In FIG. 7C, a structure in which the first pattern structure 311 and the second pattern structure 312 are arranged one by one is disclosed, but the disclosure is not limited thereto. According to an embodiment, the flexibility of the display support member 300, the distribution of pressure applied to the display 240, and/or the degree to which the display support member 300 is visually exposed to the outside of the electronic device 200 may be controlled based on the arrangement method of the first pattern structure 311 and the second pattern structure 312.

According to an embodiment, at least a portion of the display support member 300 may be formed using a cutting process. For example, the pattern structure 310 may be formed using laser processing. As another example, the pattern structure 310 may be formed using computer numerical control (CNC). According to an embodiment, the support portion 320 and the wing portion 330 may be formed integrally.

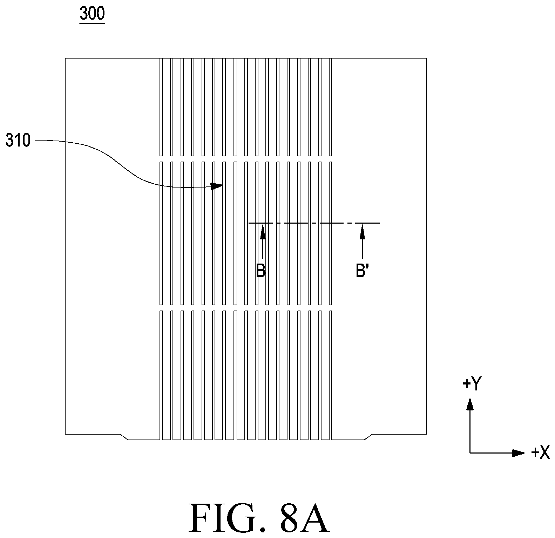

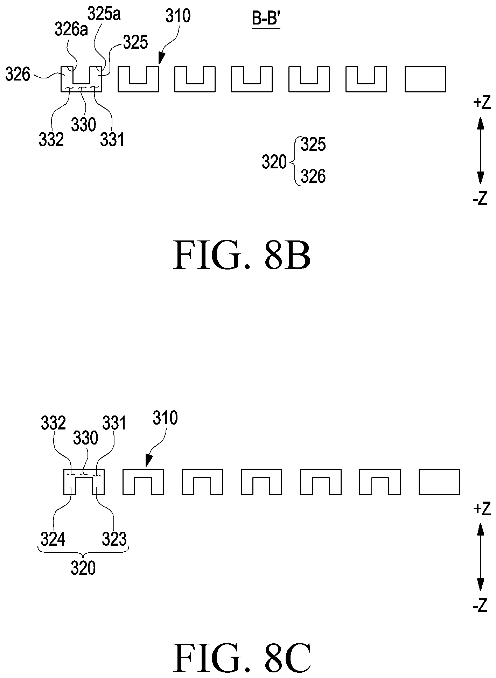

FIG. 8A is a front view of a display support member, according to an embodiment of the disclosure, and FIGS. 8B to 8C are cross-sectional views taken along line B-B' in FIG. 8A.

Referring to FIGS. 8A to 8C, a display support member 300 includes a pattern structure 310. The configurations of the display support member 300 and the pattern structure 310 in FIGS. 8A, 8B, and/or 8C may be partially or totally the same as the configurations of the display support member 300 and the pattern structure 310 in FIGS. 7A, 7B, 7C, and/or 7D. For example, the pattern structure 310 includes a support portion 320 and a wing portion 330.

According to an embodiment, the pattern structure 310 may include two support portions 320 extending from one wing portion 330. For example, the wing portion 330 may include a third end area 331 and a fourth end area 332 disposed at the opposite of the third end area 331. The support portions 320 may extend from the third end area 331 and the fourth end area 332, respectively. According to an embodiment, due to the plurality of support portions 320, the rigidity of the display support member 300 may be increased, and the visibility of the display support member 300 to the outside of the electronic device (e.g., the electronic device 200 in FIG. 1) may be decreased.

According to an embodiment (e.g., FIG. 8B), the support portion 320 may include a third support portion 325 extending from the third end area 331 in the second direction (+Z direction) and a fourth support portion 326 extending from the fourth end area 332 in the second direction (+Z direction). According to an embodiment, the third support portion 325 and/or the fourth support portion 326 may support at least a portion of the display (e.g., the display 240 in FIG. 4), and the wing portion 330 may be spaced apart from the display 240. For example, the third support portion 325 may include a third surface 325a facing the display 240, and the fourth support portion 326 may include a fourth surface 326a supporting the display 240. According to an embodiment, the configuration of the pattern structure 310 in FIG. 8B may be interpreted as a configuration in which the shape of the support portion 320 is changed from the pattern structure 310 in FIG. 7C.

According to an embodiment (e.g., FIG. 8C), the support portion 320 may include a first support portion 323 extending from the third end area 331 in a third direction (-Z direction) and a second support portion 324 extending from the fourth end area 332 in the third direction (-Z direction). According to an embodiment, the wing portion 330 may support the display (e.g., the display 240 in FIG. 4) together with the first support portion 323 and the second support portion 324. According to an embodiment, the configuration of the pattern structure 310 in FIG. 8B may be interpreted as a configuration in which the shape of the support portion 320 is changed from the pattern structure 310 in FIG. 7B.

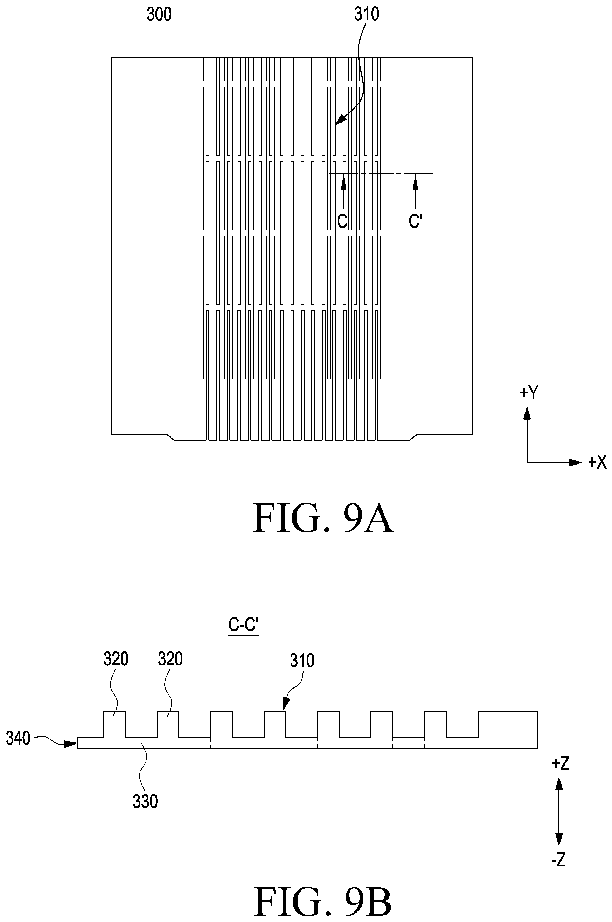

FIG. 9A is a front view of a display support member, according to an embodiment of the disclosure, and FIG. 9B is a cross-sectional view of the display support member taken along line C-C' in FIG. 9A.

Referring to FIGS. 9A and 9B, a display support member 300 includes a pattern structure 310. The configurations of the display support member 300 and the pattern structure 310 in FIG. 9A and/or FIG. 9B may be partially or totally the same as those of the display support member 300 and the pattern structure 310 in FIG. 5.

According to an embodiment, the pattern structure 310 may include an extension area 340. According to an embodiment, the extension area 340 may be interpreted as a portion of the pattern structure 310 connected to the plurality of wing portions 330. For example, the extension area 340 may be a portion of the pattern structure 310 positioned between the plurality of wing portions 330. According to an embodiment, the wing portions 330 may be connected to the plurality of support portions 320, and the wing portions 330 connected to the plurality of support portions 320 may be interpreted as the extension area 340.

According to an embodiment, the extension area 340 may thermally connect a first housing (e.g., the first housing 210 in FIG. 1) and a second housing (e.g., the second housing 220 in FIG. 1). For example, the extension area 340 may extends from the first housing 210 via a folding area (e.g., the folding area 243 in FIG. 3) of the display (e.g., the display 240 in FIG. 1) to the second housing 220. For example, the extension area 340 may extend from the first area 301 of the display support member 300 via the third area 303 to the second area 302. According to an embodiment, the components (e.g., the first battery 252 and/or the first circuit board 262) accommodated in the first housing 210 may be thermally connected, using the extension area 340, to the components (e.g., the second battery 254 and/or the second circuit board 264) accommodated in the second housing 220.

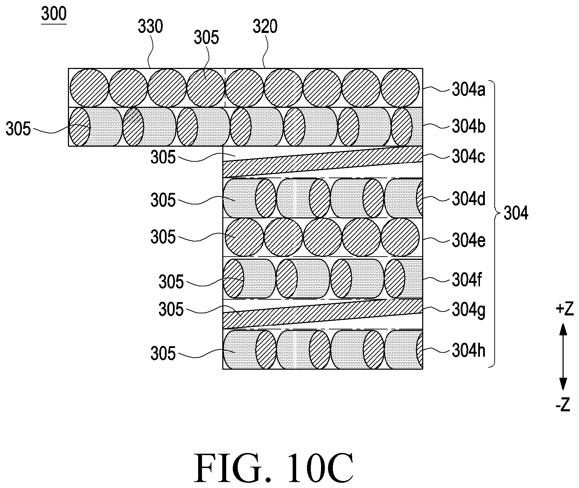

FIG. 10A is an enlarged view of area A of a display support member, according to an embodiment of the disclosure, and FIGS. 10B and 10C are cross-sectional views of the display support member in FIG. 10A.

Referring to FIGS. 10A, 10B, and/or 10C, a display support member 300 includes a pattern structure 310. The configurations of the display support member 300 and the pattern structure 310 in FIGS. 10A, 10B, and/or 10C may be partially or totally the same as those of the display support member 300 and the pattern structure 310 in FIG. 7A and/or 7B.

According to an embodiment, the display support member 300 may be bent in a third area (e.g., the third area 303 in FIG. 5) in which the pattern structure 310 is positioned. According to an embodiment, the pattern structure 310 may be formed in a shape which is bendable and has rigidity to protect the display (e.g., the display 240 in FIG. 3).

According to an embodiment, a first thickness t1 of the support portion 320 may be greater than a second thickness t2 of the wing portion 330. According to an embodiment, the second thickness t2 of the wing portion 330 may be 0.02 mm to 0.18 mm. According to an embodiment, the first thickness t1 of the support portion 320 may be 0.1 mm to 0.2 mm.

According to an embodiment, a first width w1 of the support portion 320 may be greater than a second width w2 of the wing portion 330. According to an embodiment, the second width w2 of the wing portion 330 may be 0.05 mm to 0.25 mm. According to an embodiment, the first width w1 of the support portion 320 may be 0.1 mm to 0.5 mm.

According to an embodiment, the pattern structure 310 may include a plurality of support portions 320 and a plurality of wing portions 330. For example, the pattern structure 310 may include a plurality of pattern structures 310-1 and 310-2 spaced apart from each other. A third width w3, which is the length of the gap between the plurality of pattern structures 310-1, 310-2, and 310-3, may be 0.05 mm to 0.25 mm. According to an embodiment, the length of the gap between the plurality of pattern structures 310-1, 310-2, and 310-3 may be interpreted as the third width w3 of the through-hole 318 of the pattern structure 310. According to an embodiment, the length d1 of the through-hole 318 may be 5 mm to 20 mm. According to an embodiment, the pattern structure 310 may include a bridge 319. According to an embodiment, the bridge 319 may be interpreted as a portion of the pattern structure 310 positioned between the plurality of through-holes 318. The fourth width w4 of the bridge 319 may be 0.1 mm to 1.0 m. According to an embodiment, the through-holes 318 may be interpreted as a lattice structure.

According to an embodiment, the display support member 300 may include prepreg layers 304 (e.g., the prepreg layers 304 in FIG. 6). For example, the support portion 320 and/or the wing portion 330 may include the prepreg layers 304. According to an embodiment, each of the prepreg layers 304a, 304b, 304c, 304d, 304e, 304f, 304g, and 304h may include at least one fiber 305 arranged along one direction (uni direction). According to an embodiment, the prepreg layers 304 may include a plurality of prepreg layers 304a, 304b, 304c, 304d, 304e, 304f, 304g, and 304h including the fibers 305 arranged in different directions, and thus heat transmitted to the display support member 300 may be transmitted in various directions along the fibers 305.

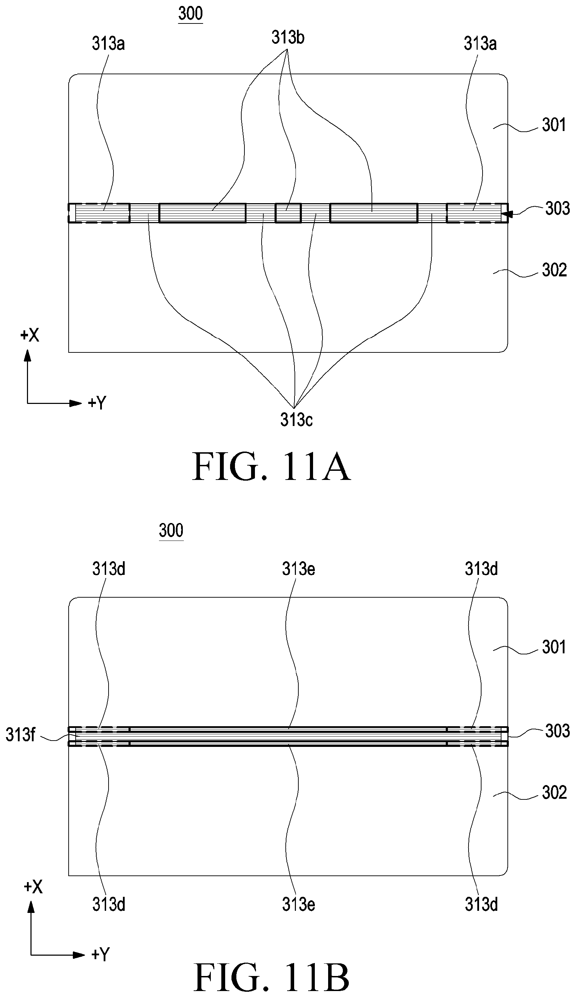

FIGS. 11A and 11B are front views of a display support member including a pattern structure having various shapes, according to an embodiment of the disclosure.

Referring to FIGS. 11A and 11B, a display support member 300 may include a first area 301, a second area 302, and a third 303. The third area 303 may include a pattern structure 310. The configuration of the display support member 300 in FIGS. 11A and 11B may be partially or totally the same as that of the display support member 300 in FIG. 5.

According to an embodiment, the display support member 300 may have pattern structures (e.g., the pattern structure 310 in FIG. 5) having different shapes. For example, the third area 303 of the display support member 300 may include the pattern structures 310 formed differently depending on the location.

According to an embodiment (e.g., FIG. 11A), the display support member 300 may include first pattern structure areas 313a, second pattern structure areas 313b, and third pattern structure areas 313c, of which the shapes are different from each other. According to an embodiment, the first pattern structure areas 313a may be positioned at both ends of the third area 303. According to an embodiment, the second pattern structure areas 313b and the third pattern structure areas 313c may be positioned between the plurality of first pattern structure areas 313a. According to an embodiment, at least a portion of the first pattern structure areas 313a may face at least a portion of a hinge module (e.g., the hinge module 202 in FIG. 4). According to an embodiment, the pattern structure (e.g., the pattern structure 310 in FIG. 5) located in the first pattern structure areas 313a may be formed as a structure to secure the flexibility of the display support member 300 and reduce rigidity. For example, the first pattern structure areas 313a may include the pattern structure 310 in FIG. 7D. According to an embodiment, the second pattern structure areas 313b may face at least a portion of the display (e.g., the display 240 in FIG. 4). For example, the second pattern structure areas 313b may be formed as a structure to improve the rigidity of the display support member 300 to protect the display 240 from external impact. For example, the second pattern structure areas 313b may include the pattern structure 310 in FIG. 8B.

According to an embodiment, at least a portion of the third pattern structure areas 313c may not face a component (e.g., the hinge module 202 in FIG. 4 and/or the flexible circuit board 266 in FIG. 3) of an electronic device (e.g., the electronic device 200 in FIG. 2). For example, the third pattern structure areas 313c may be formed as a structure to improve the thermal conductivity of the display support member 300. For example, the third pattern structure areas 313c may include the pattern structure 310 of Figure 9b.

According to an embodiment (e.g., FIG. 11B), the display support member 300 may include fourth pattern structure areas 313d, fifth pattern structure areas 313e, and a sixth pattern structure area 313f, of which the shapes are different from each other. According to an embodiment, the sixth pattern structure area 313f may be surrounded by the fourth pattern structure areas 313d and the fifth pattern structure areas 313e. According to an embodiment, the fourth pattern structure areas 313d may be positioned at both ends of the third area 303. According to an embodiment, the fifth pattern structure areas 313e may be positioned between the plurality of second pattern structure areas 313b.

According to an embodiment, at least a portion of the fourth pattern structure areas 313d may face at least a portion of the hinge module (e.g., the hinge module 202 in FIG. 4). According to an embodiment, the pattern structure (e.g., the pattern structure 310 in FIG. 5) located in the fourth pattern structure areas 313d may be formed as a structure to distribute the pressure transmitted to the display (e.g., the display 240 in FIG. 4). For example, the fourth pattern structure areas 313d may include the pattern structure 310 of FIG. 7B. According to an embodiment, at least a portion of the fifth pattern structure areas 313e may be positioned outside the third area (e.g., the third area 303 in FIG. 4). According to an embodiment, the display support member 300 may be formed in a structure to secure flexibility and reduce rigidity. For example, the fifth pattern structure areas 313e may include the pattern structure 310 in FIG. 7D.

According to an embodiment, at least a portion of the sixth pattern structure area 313f may face at least a portion of the display (e.g., the display 240 in FIG. 4). For example, the second pattern structure area 313b may be formed as a structure to improve the rigidity of the display support member 300 to protect the display 240 from external impact. For example, the sixth pattern structure area 313f may include the pattern structure 310 of FIG. 8C. The arrangement of the pattern structure (e.g., the pattern structure 310 in FIG. 5) of the disclosure is not limited to the positions disclosed in FIG. 11A and/or FIG. 11B. For example, based on the shape or location of a component located in the electronic device 200 (e.g., the hinge module 202 and/or the flexible circuit board 266 in FIG. 3), the arrangement of the pattern structure 310 may be configured in various ways.

An electronic device (for example, a portable terminal) includes a display having a flat surface or a flat surface and a curved surface. An electronic device including a display may have a limitation in implementing a screen larger than the size of the electronic device due to a fixed display structure. Accordingly, an electronic device including a foldable or rollable display is being studied.

An electronic device may receive various input from a user via a specific input device (e.g., a stylus pen) connected to the electronic device via wireless communication. The electronic device may identify the location on the electronic device designated by the input device and may perform a function corresponding thereto. For example, the electronic device may detect a magnetic field produced from the input device using an electromagnetic resonance (hereinafter, referred to as an EMR) method.

An electronic device includes a display support member configured to support a display. When the display support member is formed of conductive metal, signal distortion of an input device may occur.

According to an embodiment of the disclosure, a display support member capable of reducing the distortion of an electromagnetic wave transmitted to an input device may be provided.

According to an embodiment of the disclosure, a display support member having rigidity to protect a display may be provided. The display support member may be folded or unfolded at a portion at which a pattern structure is positioned.

## Claims

1. An electronic device (200) comprising:
a housing (201) including a first housing (210) and a second housing (220) configured to rotate with respect to the first housing (210);
a display (240) including a first display area (241) disposed on the first housing (210), a second display area (242) disposed on the second housing (220), and a folding area (243) positioned between the first display area (241) and the second display area (242); and
a display support member (300) configured to support the display (240) and formed of a composite material,
wherein the display support member (300) comprises a pattern structure (310) facing the folding area (243),
wherein the pattern structure (310) comprises a first pattern structure (311) and a second pattern structure (312) spaced apart from each other and arranged alternately,
wherein each of the first pattern structure (311) and the second pattern structure (312) comprises a support portion (320) extending along a direction substantially perpendicular to the display (240),
wherein the support portion (320) comprises a first end area (321) facing at least a portion of the display (240) and a second end area (322) opposite the first end area (321), and
wherein the first pattern structure (311) further comprises a first wing portion (333) extending from the first end area (321) of the support portion (320) of the first pattern structure (311) along a first direction parallel to at least a portion of the display (240), and the second pattern structure (312) further comprises a second wing portion (334) extending from the second end area (322) of the support portion (320) of the second pattern structure (312) along the first direction.

2. The electronic device of claim 1, wherein the composite material comprises at least one of carbon fiber reinforced plastic or glass fiber reinforced plastic.

3. The electronic device of claim 1, wherein the display support member (300) includes a first area (301) supporting the first display area (241), a second area (302) supporting the second display area (242), and a third area (303) located between the first area (301) and the second area (302) and including the pattern structure (310) formed therein, and
wherein the folding area (243) faces at least a portion of the third area (303).

4. The electronic device of claim 1, wherein the display support member (300) comprises a plurality of prepreg layers (304) arranged along at least one different direction, respectively.

5. The electronic device of claim 1, further comprising a hinge module (202) disposed in the housing (201) and facing at least a portion of the pattern structure (310).

6. The electronic device of claim 1, wherein the pattern structure (310) comprises at least one through-hole (318), and
wherein at least a portion of the at least one through-hole (318) is surrounded by the first wing portion (333) and the support portion (320) of the second pattern structure (312) and by the second wing portion (334) and the support portion (320) of the first pattern structure (311).

7. The electronic device of claim 1, wherein the display comprises a pen driving circuit.

8. The electronic device of claim 1, wherein a second thickness of the first wing portion (333) and the second wing portion (334) is smaller than a first thickness of the support portion (320).

## Patentansprüche

1. Elektronische Vorrichtung (200), umfassend:
ein Gehäuse (201), das ein erstes Gehäuse (210) und ein zweites Gehäuse (220), das dazu konfiguriert ist, sich in Bezug auf das erste Gehäuse (210) zu drehen, beinhaltet;
eine Anzeige (240), die einen ersten Anzeigebereich (241), der an dem ersten Gehäuse (210) vorgesehen ist, einen zweiten Anzeigebereich (242), der an dem zweiten Gehäuse (220) vorgesehen ist, und einen Klappbereich (243), der zwischen dem ersten Anzeigebereich (241) und dem zweiten Anzeigebereich (242) positioniert ist, beinhaltet; und
ein Anzeigestützelement (300), das dazu konfiguriert ist, die Anzeige (240) zu stützen und aus einem Verbundmaterial gebildet ist,
wobei das Anzeigestützelement (300) eine Musterstruktur (310) umfasst, die dem Klappbereich (243) zugewandt ist,
wobei die Musterstruktur (310) eine erste Musterstruktur (311) und eine zweite Musterstruktur (312) umfasst, die voneinander beabstandet und abwechselnd angeordnet sind,
wobei jede von der ersten Musterstruktur (311) und der zweiten Musterstruktur (312) einen Stützabschnitt (320) umfasst, der sich entlang einer Richtung im Wesentlichen senkrecht zu der Anzeige (240) erstreckt,
wobei der Stützabschnitt (320) einen ersten Endbereich (321), der zumindest einem Abschnitt der Anzeige (240) zugewandt ist, und einen zweiten Endbereich (322) gegenüber dem ersten Endbereich (321) umfasst, und
wobei die erste Musterstruktur (311) ferner einen ersten Flügelabschnitt (333) umfasst, der sich von dem ersten Endbereich (321) des Stützabschnittes (320) der ersten Musterstruktur (311) entlang einer ersten Richtung parallel zu zumindest einem Abschnitt der Anzeige (240) erstreckt, und die zweite Musterstruktur (312) ferner einen zweiten Flügelabschnitt (334) umfasst, der sich von dem zweiten Endbereich (322) des Stützabschnittes (320) der zweiten Musterstruktur (312) entlang der ersten Richtung erstreckt.

2. Elektronische Vorrichtung nach Anspruch 1, wobei das Verbundmaterial zumindest eines von kohlenstofffaserverstärktem Kunststoff oder glasfaserverstärktem Kunststoff umfasst.

3. Elektronische Vorrichtung nach Anspruch 1, wobei das Anzeigestützelement (300) einen ersten Bereich (301), der den ersten Anzeigebereich (241) stützt, einen zweiten Bereich (302), der den zweiten Anzeigebereich (242) stützt, und einen dritten Bereich (303), der sich zwischen dem ersten Bereich (301) und dem zweiten Bereich (302) befindet und die Musterstruktur (310) beinhaltet, die darin gebildet ist, beinhaltet und
wobei der Klappbereich (243) zumindest einem Abschnitt des dritten Bereichs (303) zugewandt ist.

4. Elektronisches Vorrichtung nach Anspruch 1, wobei das Anzeigestützelement (300) eine Vielzahl von Prepreg-Schichten (304) umfasst, die jeweils entlang zumindest einer unterschiedlichen Richtung angeordnet sind.

5. Elektronische Vorrichtung nach Anspruch 1, ferner umfassend ein Scharniermodul (202), das in dem Gehäuse (201) angeordnet ist und zumindest einem Abschnitt der Musterstruktur (310) zugewandt ist.

6. Elektronische Vorrichtung nach Anspruch 1, wobei die Musterstruktur (310) zumindest ein Durchgangsloch (318) umfasst und
wobei zumindest ein Abschnitt des zumindest einen Durchgangslochs (318) durch den ersten Flügelabschnitt (333) und den Stützabschnitt (320) der zweiten Musterstruktur (312) und durch den zweiten Flügelabschnitt (334) und den Stützabschnitt (320) der ersten Musterstruktur (311) umgeben ist.

7. Elektronische Vorrichtung nach Anspruch 1, wobei die Anzeige eine Stiftantriebsschaltung umfasst.

8. Elektronische Vorrichtung nach Anspruch 1, wobei eine zweite Dicke des ersten Flügelabschnittes (333) und des zweiten Flügelabschnittes (334) kleiner als eine erste Dicke des Stützabschnittes (320) ist.

## Revendications

1. Dispositif électronique (200) comprenant :
un boîtier (201) comprenant un premier boîtier (210) et un second boîtier (220) conçu pour tourner par rapport au premier boîtier (210) ;
un écran (240) comprenant une première zone d'écran (241) disposée sur le premier boîtier (210), une seconde zone d'écran (242) disposée sur le second boîtier (220), et une zone de pliage (243) positionnée entre la première zone d'écran (241) et la seconde zone d'écran (242) ; et
un élément de support d'écran (300) conçu pour supporter l'écran (240) et formé d'un matériau composite,
dans lequel l'élément de support d'écran (300) comprend une structure à motifs (310) faisant face à la zone de pliage (243),
dans lequel la structure à motifs (310) comprend une première structure à motifs (311) et une seconde structure à motifs (312) espacées l'une de l'autre et agencées alternativement,
dans lequel chacune de la première structure à motifs (311) et de la seconde structure à motifs (312) comprend une partie de support (320) s'étendant selon une direction sensiblement perpendiculaire à l'écran (240),
dans lequel la partie de support (320) comprend une première zone d'extrémité (321) faisant face à au moins une partie de l'écran (240) et une seconde zone d'extrémité (322) opposée à la première zone d'extrémité (321), et
dans lequel la première structure à motifs (311) comprend en outre une première partie en aile (333) s'étendant à partir de la première zone d'extrémité (321) de la partie de support (320) de la première structure à motifs (311) selon une première direction parallèle à au moins une partie de l'écran (240), et la seconde structure à motifs (312) comprend en outre une seconde partie en aile (334) s'étendant à partir de la seconde zone d'extrémité (322) de la partie de support (320) de la seconde structure à motifs (312) selon la première direction.

2. Dispositif électronique de la revendication 1, dans lequel le matériau composite comprend au moins l'un d'un plastique renforcé de fibres de carbone ou d'un plastique renforcé de fibres de verre.

3. Dispositif électronique de la revendication 1, dans lequel l'élément de support d'écran (300) comprend une première zone (301) supportant la première zone d'écran (241), une deuxième zone (302) supportant la seconde zone d'écran (242), et une troisième zone (303) située entre la première zone (301) et la deuxième zone (302) et comprenant la structure à motifs (310) formée dans celle-ci, et
dans lequel la zone de pliage (243) fait face à au moins une partie de la troisième zone (303).

4. Dispositif électronique de la revendication 1, dans lequel l'élément de support d'écran (300) comprend une pluralité de couches préimprégnées (304) agencées selon au moins une direction différente, respectivement.

5. Dispositif électronique de la revendication 1, comprenant en outre un module de charnière (202) disposé dans le boîtier (201) et faisant face à au moins une partie de la structure à motifs (310).

6. Dispositif électronique de la revendication 1, dans lequel la structure à motifs (310) comprend au moins un trou traversant (318), et
dans lequel au moins une partie de l'au moins un trou traversant (318) est entourée par la première partie en aile (333) et la partie de support (320) de la seconde structure à motifs (312) et par la seconde partie en aile (334) et la partie de support (320) de la première structure à motifs (311).

7. Dispositif électronique de la revendication 1, dans lequel l'écran comprend un circuit de commande de stylet.

8. Dispositif électronique de la revendication 1, dans lequel une seconde épaisseur de la première partie en aile (333) et de la seconde partie en aile (334) est inférieure à une première épaisseur de la partie de support (320).
